# EUROPEAN PATENT APPLICATION

(11) **EP 4 283 821 A1**
(43) Date of publication of application: **29.11.2023**
(21) Application number: 22175864.2
(22) Date of filing: 27.05.2022
(51) Int. Cl.: H02J 7/00, H01M 10/42

(54) **A DEVICE, AND CORRESPONDING METHOD, FOR CELL BALANCING IN AN ELECTRIC BATTERY SYSTEM**

(71) Applicant: Dukosi Limited, Edinburgh, EH14 4AP (GB)
(72) Inventor: QUINN, Simon, Edinburgh, EH14 4AP (GB); MCVEIGH, Gavin, Edinburgh, EH14 4AP (GB); SYLVESTER, Joel, Edinburgh, EH14 4AP (GB)
(74) Representative: Finnegan Europe LLP

(57) **Abstract**

The present disclosure relates to a battery pack of an electric battery system, for balancing individual cells within the battery pack with respect to voltage, charge and/or state of charge. The electric battery system comprises at least one pack, each pack comprising a plurality of battery cells, and each battery cell is monitored via a cell monitoring device (CMD), which provides cell-level measurements. Cell balancing is provided in a manner which allows for the simultaneous measuring of a cell-level balancing current and a cell-level balancing voltage during the balancing. Such measuring allows for control of the cell balancing without having to continuously interrupt and restart the cell balancing procedure.

## Description

### BACKGROUND

Battery systems, comprising a plurality of battery cells, are used in a wide range of modern electric power applications. For example, they are used to power electric vehicles, they are used in industrial power applications, in transportation, and in commercial applications such as powering of modern electronic devices. Given the relatively high-power demands of such applications, a battery system often comprises a plurality of battery cells coupled together to achieve the required power output. The battery cells may be coupled together to form a battery pack, and the battery system may comprise one or more battery packs.

The individual cells in a battery pack may comprise different capacities, which may also vary over time due to different rates of degradation, and therefore over the course of multiple charge and discharge cycles, the cells may comprise a different state of charge. State of charge (SOC) is defined as the ratio of the available capacity and the maximum possible charge that may be stored in a battery cell. Balancing the cells of a multiple cell battery pack may assist in improving the capacity and life of the battery pack by maintaining an equivalent (or balanced) state of charge level at each cell within the pack.

### SUMMARY

Current means of cell balancing do not allow for obtaining measurements useful to the monitoring and control of the cell balancing during the balancing itself. Therefore, current means of balancing require the balancing procedure to be stopped periodically in order to obtain cell-level measurements related to, for example, state of charge, cell-level balancing voltage and/or cell-level balancing voltage. Thus, the example embodiments presented herein provide a means of cell balancing in which measurements useful in controlling the balancing procedure may be obtained without interrupting the balancing procedure.

Accordingly, the example embodiments are directed towards a battery pack comprising a plurality of cell monitoring devices (CMDs) for balancing cells within the battery pack with respect to voltage, charge and/or state of charge. The battery pack comprises a plurality of battery cells, wherein each battery cell is monitored via a respective cell monitoring device (CMD) which provides cell-level measurements. Each CMD comprises a measuring unit comprising at least one sensor configured to obtain a cell-level voltage measurement and/or a cell-level charge measurement of the respective cell. Each CMD further comprises a balance control unit configured to identify a respective cell for cell balancing based on the measured cell-level voltage, the measured cell-level charge and/or a determined state of charge of the respective cell. The balance control unit is further configured to balance the respective cell via a discharging or charging of the respective cell. The balance control unit is further configured to measure a cell-level balancing current of the respective cell during the cell balancing, and further configured to control the cell balancing of the respective cell based on the measured cell-level balancing current.

The example embodiments are also directed towards a method, in a battery pack of an electric battery system, for balancing cells within the battery pack with respect to voltage, charge and/or state of charge. The electric battery system comprises at least one pack, each pack comprising a plurality of battery cells, wherein each battery cell is monitored via a cell monitoring device (CMD) which provides cell-level measurements. The method comprises obtaining, with at least one sensor comprised in a respective CMD, a cell-level voltage measurement and/or a cell-level charge measurement of the respective cell. The method also comprises identifying at least one cell of the plurality of battery cells to undergo cell balancing based on the respective cell-level voltage measurement, cell-level charge measurement and/or a determined cell-level state of charge. The method further comprises balancing the at least one identified cell of the battery pack via a charging or discharging of the at least one identified cell. The method additionally comprises measuring a cell-level balancing current of the at least one identified cell during the balancing, and controlling the balancing of the at least one identified cell based on the measured cell-level balancing current.

The example embodiments also comprise a computer-readable medium storing instructions which, when executed by a processor of a respective CMD of a batter pack, cause the respective CMD to execute the method described above.

### BRIEF DESCRIPTION OF THE DRAWINGS

The foregoing will be described in more detail with the following more particular description of the example embodiments, as illustrated in the accompanying drawings in which reference characters refer to the same parts throughout the different views. The drawings are not necessarily to scale, emphasis instead being placed upon illustrating the example embodiments.
**FIG. 1** is a schematic of an electric battery system;
**FIG. 2** is a graph illustrating the relationship between open circuit voltage and state of charge associated with a battery cell;
**FIG. 3** is a schematic of the electric battery system of **FIG. 1** featuring a multiplexed input;
**FIG. 4** is a schematic of an electric battery system, according to the example embodiments presented herein;
**FIG. 5** is an illustration of an example Cell Monitoring Device (CMD) of **FIG. 4****,** according to some of the example embodiments presented herein;
**FIG. 6** is an illustration of another example CMD, featuring a kelvin connection, of **FIG. 4****,** according to some of the example embodiments presented herein;
**FIG. 7** is a flow diagram depicting operation steps taken by CMD(s) of **FIGS. 4-****6,** according to some of the example embodiments presented herein; and
**FIGS. 8** and **9** are graphs depicting the relationship of cell voltage over time during a cell balancing procedure, according to some of the example embodiments presented herein.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

A battery system typically comprises multiple cells wired in a configuration to provide the desired battery system voltage and capacity and additional parts necessary for the safe operation of the cells and transfer of energy to/from the cells. A cell is the basic unit of any battery system. The defining characteristic of a cell is its electrochemical characteristics. For a particular cell chemistry, there is a minimum, typical and maximum voltage that is determined by the electrochemistry of the system, rather than the configuration of the system. These voltages cannot be varied other than by changing the electrochemical state of the cell. Cells may be wired in parallel, to increase the overall capacity, but these paralleled cells can simply be regarded from a cell monitoring perspective as a larger single cell since they still have the same voltage characteristics as determined by the electrochemistry.

Cells can also be wired in series. The series stack of cells has a voltage primarily determined by the stack configuration. The stack voltage will be the sum of the cell voltages. The stack voltage can be varied by adding or removing cells without changing their electrochemical state. Typically, the stack of cells will be charged and discharged, with their electrochemical state changing in tandem. Each cell must be monitored to ensure it stays within its safe operating range. This is the job of the cell monitoring device (CMD). CMDs provide cell-level measurements such that separate measurements are taken on individual cells and the information obtained is with respect to an individual cell.

A battery pack consists of multiple cells in series. The battery pack provides the full battery system voltage. Multiple battery packs may be wired in parallel to increase the battery system capacity, but not in series. The cells may be grouped into modules. The defining characteristic of a module is its physical configuration, for example, the number and connectivity between a number of cells. A module may comprise of any number of cells. A module comprises of two or more cells, or an entire pack. In the case of there being only a single pack in the battery system, then a module could encompass an entire battery system.

More often though, a pack is configured as multiple modules, where each module is configured from multiple cells in series. Multiple modules are then wired in series, or in parallel and in series. Modules that are configured to provide the full the battery system voltage and are wired in parallel may be considered as packs. A module has a defined size, shape and is typically packaged in an enclosure of some kind.

The module configuration is driven by the physical requirements of the battery pack. Often a module is configured to have a low enough voltage that it can be handled without there being an electrical shock hazard. Often a module is configured for a number of cells that matches the number of voltage sensor inputs on a cell monitoring device. A very common example is a twelve cell monitoring device. A module then consists of twelve cells and a connection to a cell monitoring device. In many battery packs, the properties of the CMD define the configuration of a module, and the battery pack is then built from multiple such modules.

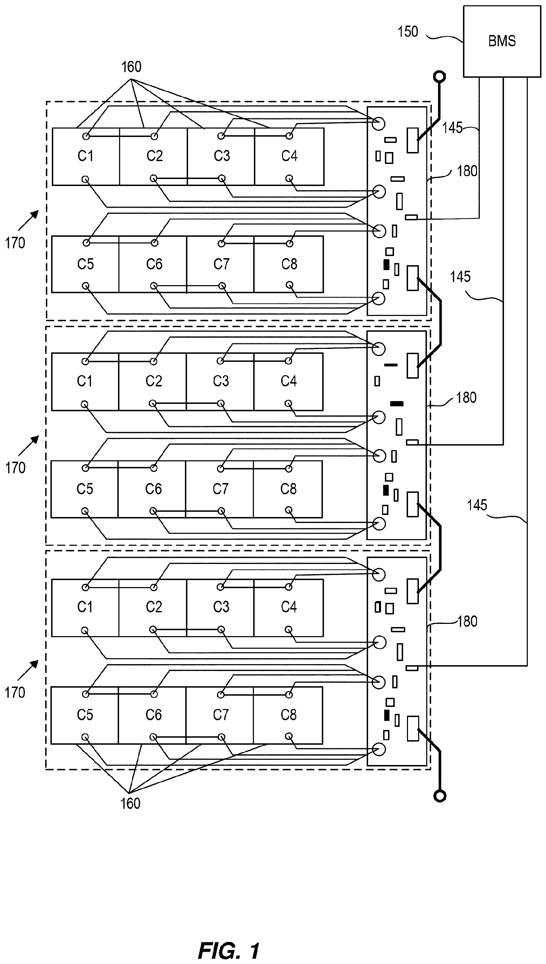

Figure 1 illustrates a known prior art system. The battery system of Figure 1 comprises three battery modules 170, with each battery module comprising eight battery cells (C1-C8) 160. Each battery cell C1-C8, within each battery module 170, is hardwired to a respective CMD 180. The position of each cell C1-C8 within battery module 170 may be mapped during assembly of battery module 170. In use, CMD 180 receives measurement data from each one of cells C1-C8, and can determine the source of the received measurement data based on the pre-defined cell mapping information. CMDs 180 illustrated in Figure 1 are connected in a star topology. Alternatively, each CMD 180 may be connected to Battery Management System (BMS) via a series daisy chain connection. A star topology is advantageous since there is no communication hierarchy imposed on BMS 150, and instead communication with each CMD 180 is by direct wired connection without use of any proxies.

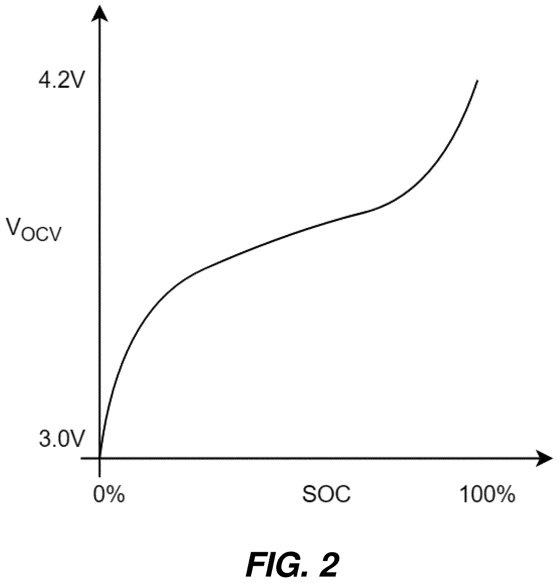

A battery pack consisting of multiple lithium ion cells will, over time, go out of balance. At manufacture, every cell will be at the exact same state of charge (SOC) when it is assembled into a pack, as indicated by every cell having the exact same voltage across the cells terminals (the terminal voltage). This may be 100% SOC, or a lower (safer) level such as 30% SOC. Alternatively, the cells may all be at the exact same terminal voltage. State of Charge SOC is directly mapped to the cell terminal open circuit voltage. Figure 2 illustrates the function relating SOC to the open circuit voltage V_{ocv}, and the function is highly non-linear, and the terminal voltage (Vterm) only equals V_{ocv} when the current is zero and the cell is rested.

If all battery cells were ideal, then as the pack is charged and discharged the terminal voltage and SOC for all the cells would track each other. In practice though, every cell will have manufacturing variations (capacity variance, resistance variance) and small operating condition variations. An example variance is the cell temperature, where it is not unusual to see a 5°C variation in cell operating temperature across a pack.

Every cell has a small self discharge current. Left alone, a cell will slowly discharge without any external load. This process may take many months or even years. The self discharge current is always present, but is usually only measurable when the cell is otherwise not being charged or discharged, and only then over very long periods of time. The self discharge current may be higher at high temperatures and lower at low temperatures. The self discharge current may also depend on the manufacturing variations as well. Over months or years, due to the differences in self discharge current seen by each cell, a pack will go out of balance. Cells that have a large self discharge current will be sitting at a lower voltage than cells that see a smaller self discharge current.

When a pack is charged, the charging process must stop as soon as the first cell reaches its maximum allowable voltage Vₘₐₓ. To continue to charge beyond this point may lead to damage to the cell. However, because all cells are in series, if charging stops for one cell, it stops for all cells. Thus, any cell at a lower voltage, or SOC, will not be fully charged. Similarly, when a pack is discharged, the discharge process must stop as soon as the first cell reaches its allowable minimum voltage Vmin. Any cell at a higher voltage or SOC will not be fully discharged.

Thus, the pack capacity is determined by the charge that will take a pack from the state where a single cell that happens to have the highest voltage is sitting at Vₘₐₓ, to the state where a single cell that happens to have the lowest voltage is sitting at Vmin. Ideally, this should be the same cell, as the pack capacity is then determined by the cell with the lowest actual capacity. In practice, it will be determined by different cells, as over time the cells will be sitting at different voltages due to self discharge. An out of balance pack will appear to have a lower useable capacity, even though each individual cell will have a higher capacity.

Therefore, cell balancing is needed to assist in keeping the cells of the battery pack balanced with respect to charge, voltage and/or state of charge. During cell balancing, it is useful to know current values for voltage, current and/or state of charge values of the cells to be balanced to properly monitor and control the balancing. Typical battery systems, such as the system illustrated in Figure 1 are unable to monitor the cells during the balancing process and instead must periodically stop the cell balancing procedure in order to obtain voltage, current and state of charge measurements.

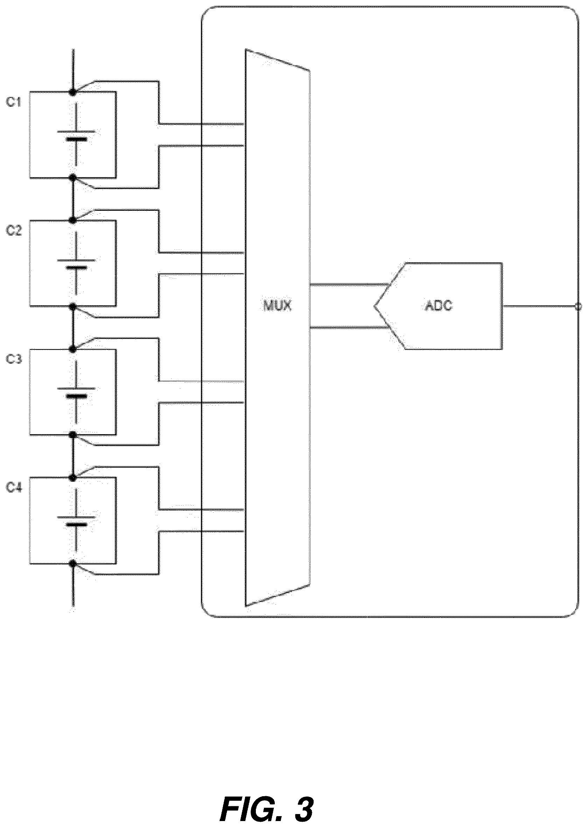

One reason the system of Figure 1 is unable to obtain measurements during cell balancing is the hardware architecture. Specifically, as shown in Figure 1, each cell C1-C8 makes two wired connections with the CMD 180. Thus, for a battery module featuring eight cells, sixteen wired connections to the CMD must be made. In order to obtain measurements during balancing for such a configuration, a multiplexer (MUX) would be required, as shown in Figure 3. However, as the number of cells, modules and battery packs increase within a single system, the hardware configuration of such a solution becomes complex.

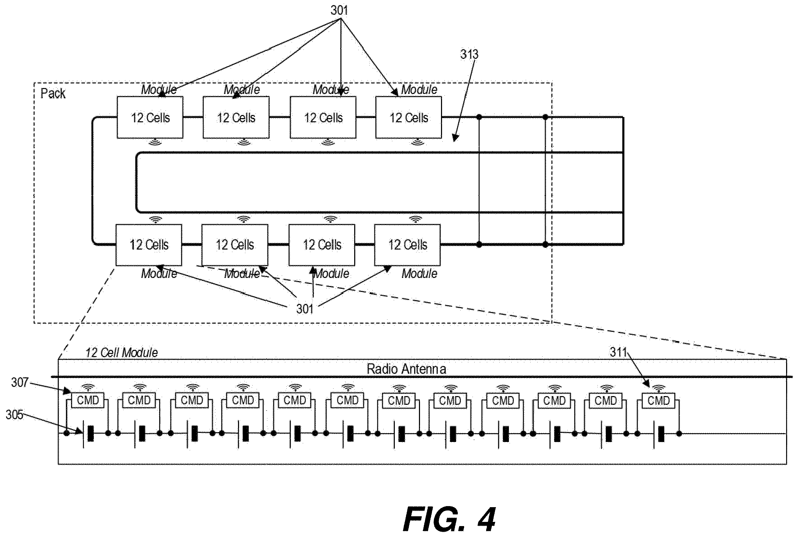

According to the example embodiments, a system for cell balancing which allows for monitoring and measurement taking to occur during the cell balancing procedure is provided. An example of such a system is illustrated in Figure 4. The system of Figure 4 illustrates a battery pack featuring eight battery modules 301, with each module featuring twelve battery cells. Each battery cell 305 is in communication with a respective CMD 307 which provides various measurements for the associated cell. All the CMDs 307 are in communication with each other and a central controller via a radio antenna 311 and a wireless communications bus 313. It is understood that, as described herein, according to other example embodiments, each module features another number of battery cells, each battery cell being in communication with a respective CMD. According to yet another example embodiment, some of the modules may feature a different number of battery cells than the other modules of the same system.

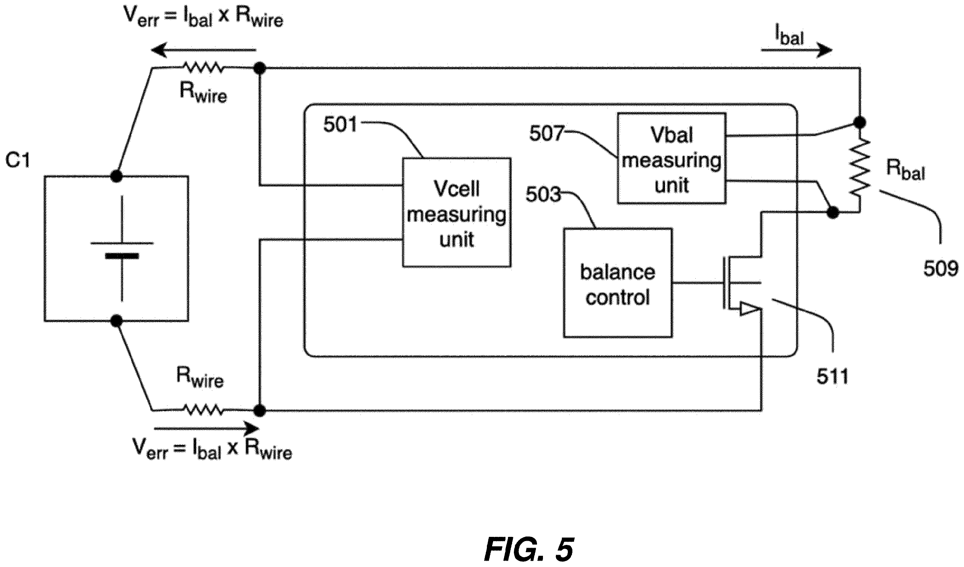

Figure 5 illustrates an example configuration of the CMD, according to some of the example embodiments. The CMD comprises a measuring unit 501. The measuring unit may comprise any number or type of sensor used in monitoring an electric battery system. Examples of such sensors may include temperature, voltage, and current based sensors. In figure 5, measuring unit 501 is configured to measure the cell voltage.

The CMD may also comprise a balancing control unit 503 which may be a controller or processor configured to balance the cell associated with the respective CMD if the said cell is identified as needing cell balancing. A field effect transistor (FET) 505 is in communication with the balancing control unit 503. The CMD of Figure 5 further comprises a balance resistor R_{bal} which is configured to be switched by the balancing control unit 503. A cell-balancing current I_{bal} and a cell-balancing voltage V_{bal} may be measured via the balance resistor R_{bal}, for example, via a measuring unit 507. The CMD further comprises parasitic resistance R_{wire} in the connections situated between the CMD and each respective cell where a cell-level voltage measurement V_{cell} may be obtained.

According to some of the example embodiments, the CMD of Figure 5 may be configured to perform passive balancing which involves decreasing the charging current, or increasing the discharge current, on an individual cell, such that a cell at a low voltage relative to other cells in the pack is charged at a lower rate, or a cell at a high voltage relative to the other cells in the pack is discharged at a higher rate. For example, this brings the cell's voltage down faster than the other cells that are not being balanced. By measuring the cell voltage and determining which cells are at a high potential relative to the others, the cells that need balancing can be selected.

The decrease in charge current, or increase in discharge current, may be achieved by drawing a current that bypasses the cell. This may be done by switching a resistive load in parallel with the cell, namely, R_{bal}. Some of the cell charge current then bypasses the cell by flowing through the balance resistor on charge, or, the cell discharge current is increased by the additional current flowing through the balance resistor. According to some of the example embodiments, balance resistor (R_{bal}) may be a simple resistor, or a current source of some kind (current source connected MOSFET), or a switch operating as a pulse width modulated load, or some combination thereof.

Because of the cell-level voltage changing during the balancing procedure, a voltage error (Vₑᵣᵣ) will not be constant. However, as each cell is individually monitored during cell balancing, the voltage error Vₑᵣᵣ may be continuously calculated and compensated for. In figure 5, a second measuring unit 507 measures the voltage V_{bal} across the balancing resistor R_{bal}. The value of R_{bal} will be known by design. The balancing current can then be calculated I_{bal} = V_{bal} / R_{bal}. For example, the voltage error is equal to the balancing current over the parasitic resistance over the connection with the individual cell (Vₑᵣᵣ= R_{wire} x I_{bal}). Thus, by knowing the voltage error V_{err,} the cell-level voltage measurement may be compensated by taking into account the known error, specifically, V_{cell_compensated} = Vₑᵣᵣ+ V_{cell}. It should be noted, in prior art systems (e.g., the system of Figure 1), cell balancing would need to be paused in order to allow for the voltage error to return to zero before measuring the cell-level voltage. Such means of providing cell balancing is not efficient. It should also be noted that the value for R_{wire} can be determined by measuring the change in voltage V_{cell} whilst switching current I_{bal} on and off under controlled conditions. The value for I_{bal} is useful for compensating for Verr, but also for calculating the balancing power and energy.

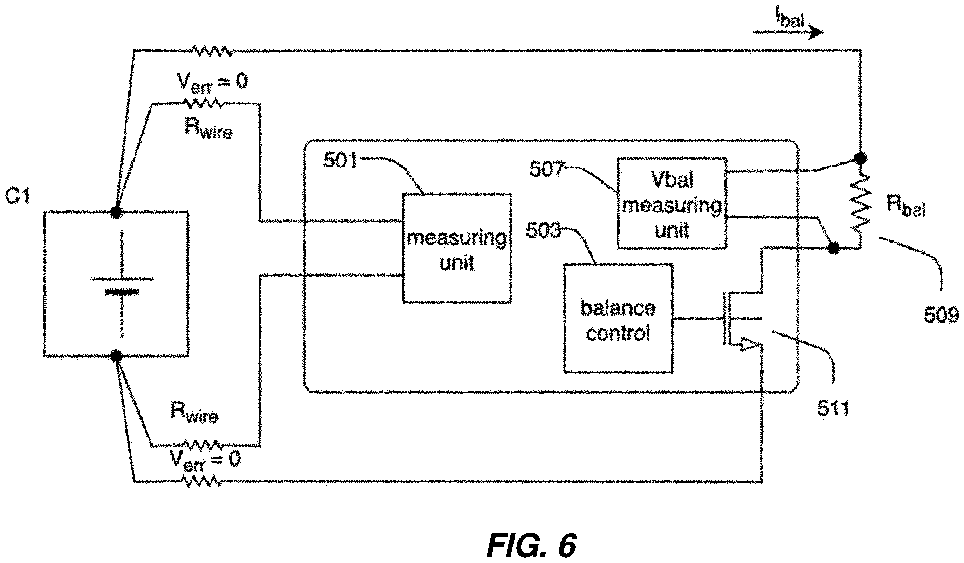

Figure 6 illustrates another example configuration of the CMD, according to some of the example embodiments. The CMD configuration of Figure 6 includes a kelvin connection between the CMD and the respective battery cell, where four connections are provided. In such a configuration, the cell-balancing current I_{bal} is not affected by the parasitic resistance, R_{wire} Thus, this removes the voltage and current fluctuation and therefore, it is possible to eliminate the voltage error (Vₑᵣᵣ = 0), at the cost that the balance resistor cannot share connections with 501.

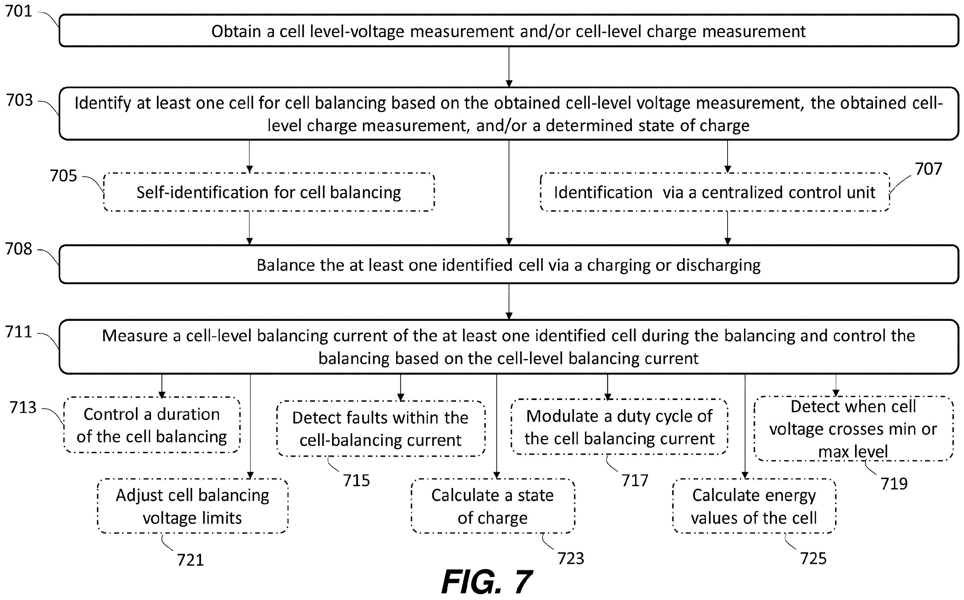

Figure 7 is a flow diagram depicting example operations which may be taken by the CMD of Figures 5 and 6 as described herein in providing cell balancing for a respective cell in a battery pack. It should be appreciated that Figure 7 comprises some operations which are illustrated with a solid border and some operations which are illustrated with a dashed border. The operations which are comprised in a solid border are operations which are comprised in the broadest example embodiments. The operations which are comprised in the dashed border are example embodiments which may be comprised in, or a part of, or are further operations which may be taken in addition to the operations of the broader example embodiments. It should also be appreciated that the actions may be performed in any order and any combination.

### Operation 701

According to the example embodiments presented herein, the measuring unit 501 is configured to obtain, with at least one sensor comprised in (or in connection with) the CMD, or within the measuring unit itself, a cell-voltage measurement (V_{cell}) and/or a cell-level charge measurement (I_{cell}) of the respective cell. As illustrated in Figures 5 and 6, such measurements may be obtained via the parasitic connection resistance in direct communication with respective cell, R_{wire}. As illustrated in Figure 5 such measurements may be obtained via a connection with the respective cell common to the balance current path. The parasitic connection resistance Rwire develops a measurement error Verr due to the balance current Ibal flowing through it. As illustrated in Figure 6, such measurement may be obtained by a connection with the respective cell via a separate path to that used by the balance current. In this case, the voltage error on the measurement is reduced to near zero.

### Operation 703

According to the example embodiments, the balancing control unit 503 is configured to identify at least one cell of the plurality of battery cells to undergo cell balancing based on the respective cell-level voltage measurement (V_{cell}), cell-level charge measurement (I_{cell}) and/or a determined cell-level state of charge. The cell-level state of charge may be calculated based on the cell-level voltage measurement and/or the cell-level charge measurement.

### Example operation 705

According to some of the example embodiments, the balancing control unit 503 may be configured to identify the at least one cell of the plurality of battery cells based on a self-identification. Specifically, a CMD may be able to determine the need for cell-balancing an associated cell without receiving explicit instructions to do so.

According to some of the example embodiments, a balancing control unit 503 may self-identify a need for cell balancing based on a cell-level voltage, charge or state of charge, of a respective cell, surpassing a deliberate voltage or charge target threshold. A deliberate voltage threshold may be used in top balancing where a cell is deliberately charged, thereby surpassing a deliberate voltage threshold, to initiate the balancing process. A charge target threshold may be used to determine if an amount of charge of a respective cell has drifted above a level of charge deemed acceptable for the cells of the battery pack. If so, top balancing may be employed.

According to some of the example embodiments, balancing control unit 503 may self-identify the need for cell balancing based on a cell-level voltage, charge or state of charge not falling within a predefined bottom balancing threshold or voltage or charge. In this case, the measured parameters of the respective cell fall below the acceptable level associated with the cells of the battery pack. In this instance, balancing is provided via bottom balancing.

According to some of the example embodiments, the balancing control unit 503 may self-identify based on a cell-level voltage, charge or state of charge difference of the respective cell in relation to at least one other cell within the battery pack. In such example embodiments, a CMD may have knowledge of measurements taken by one or more other CMDs within the battery pack. According to some of the example embodiments, the CMDs may be in communication with one another via the wireless communications bus and/or each CMD may report its respective measurements and have access to a centralized location for storing obtained measurements. Thus, once a CMD detects obtained measurements of its respective cell differ with respect to the measurements obtain by a different CMD, in relation to another cell, within the battery pack, cell balancing may be initiated, for example, based on the size of the measurement difference. An example of an acceptable level of measurement difference between different cells may be 50mV, where lower values would result in balancing occurring more frequently and higher values may reduce the effective capacity of the battery pack.

### Example operation 707

According to some of the example embodiments, the balancing control unit 503 may be configured to identify the at least one cell for cell balancing via a centralized control unit. According to such embodiments, the CMD may transmit, via a respective radio antenna, the cell-level voltage, state of charge, and/or charge measurement, to the centralized control unit via the wireless communications bus. The CMD may also receive, from the centralized control unit, instructions to cell balance its associated cell based on the respective the cell-level voltage, state of charge, and/or charge measurement.

### Operation 708

The example embodiments further comprise balancing the at least one identified cell via a charging or discharging of the identified cell. For example, in the case of top balancing, balancing will be provided via a reduction in the effective charge rate on the cell being balanced. In the case of bottom balancing, balancing is provided via an increase in the effective discharge rate of the cell being balanced, of the identified cell.

### Operation 711

The example embodiments further comprise measuring a cell-balancing current (I_{bal}) of the at least one identified cell during balancing and controlling the balancing based on the measured cell-level balancing current. Thus, in contrast to prior art systems where the balancing process must be suspended in order to properly monitor the balancing, the example embodiments provided herein provide the possibility of monitoring the balancing process continuously without suspending cell balancing. For example, cell-balancing current (I_{bal}) is measured via resistor R_{bal}.

### Example operation 713

According to some of the example embodiments, the balancing control unit 503 may be configured to control a duration of the balancing of the at least one identified cell. Specifically, by monitoring the cell-level balancing current, a rate of discharge and/or charging may be evaluated to ensure balancing is performed such that the balanced cell will reach the desired level of charge.

### Example operation 715

According to some of the example embodiments the balancing control unit 503 may be configured to control the cell balancing by detecting faults within cell-balancing current I_{bal}. Specifically, the balancing control unit 503 may detect when the cell balancing current has surpassed a maximum allowable level to ensure proper operation of the battery cell. Or, there may be a maximum power that can safely be dissipated on the battery cell, or a maximum temperature it can be allowed to reach. In each case, the balancing current I_{bal} may be reduced or switched off to avoid a fault.

### Example operation 717

According to some of the example embodiments, the balancing control unit 503 may also be configured to modulate cell balancing current I_{bal}. As explained above, passive balancing decreases a charging current, or increases a discharge current, in order to increase the rate at which a cell's voltage is adjusted during the balancing. The modulating of the cell balancing current aids in maintaining a desired average current level to achieve the desired balancing of the cell.

### Example operation 719

According to some of the example embodiments, the balancing control unit 503 is also configured to measure a cell-level voltage (V_{cell}) during the balancing of the at least one identified cell. In such embodiments, balancing control unit503 may also be configured to detect when the measured cell-level voltage is below a minimal cell-level voltage for maintaining safe cell operation, or above a maximum safe voltage. However, the true V_{cell} voltage may be higher than measured when balancing, due to the error voltage across R_{wire} (as explained in relation to Figure 5). Operation 719, by knowing the balance current I_{bal}, can compensate for the error voltage, allowing a better judgement of when a threshold is crossed.

### Example operation 721

According to some of the example embodiments, the balancing control unit 503, while measuring the cell-level voltage during the balancing of the at least one identified call, is further configured to adjust cell balancing voltage limits during the balancing. Every cell has an effective internal series resistance Rs. The switching on of balance current I_{bal} may cause a voltage drop at the cells terminals of I_{bal} x Rs. A cell may be determined to require balancing at, for example, operation 711. However, when the balancing current is turned on, then the cell voltage will drop, which may turn balancing off again.

Example operation 721 is the CMD, knowing the balance current I_{bal}, adjusting the voltage threshold such that it determines the need to balance on a first threshold, but determines the need to continue balancing on a second voltage threshold limit. This second voltage threshold limit may be adjusted during the process in response to the balance current as it varies.

### Example operation 723

According to some of the example embodiments, the balancing control unit 503, while obtaining measurements of the cell-level balancing current and the cell-level voltage, is configured to calculate a state of charge during the cell balancing. In contrast to prior art systems which require a suspension of the balancing procedure in order to determine the state of charge, the example embodiments provide a means of determining and monitoring the state of charge throughout the balancing process. This then makes it possible to control (e.g., adjust the rate of charge or discharge) the balancing process more efficiently and accurately, for example, using state of charge determined or monitored in real time.

### Example operation 725

According to some of the example embodiments, the balancing control unit 503 may be further configured to calculate energy values of a respective cell undergoing cell balancing via an integration of measured cell-level balancing current (I_{bal}) and measured cell-level voltage (V_{cell}) over time. An example of a calculated energy of the cell is a cell's power expressed in Watt-hours (Wh). Monitoring of such values assist in ensuring the cell is balanced to a proper level.

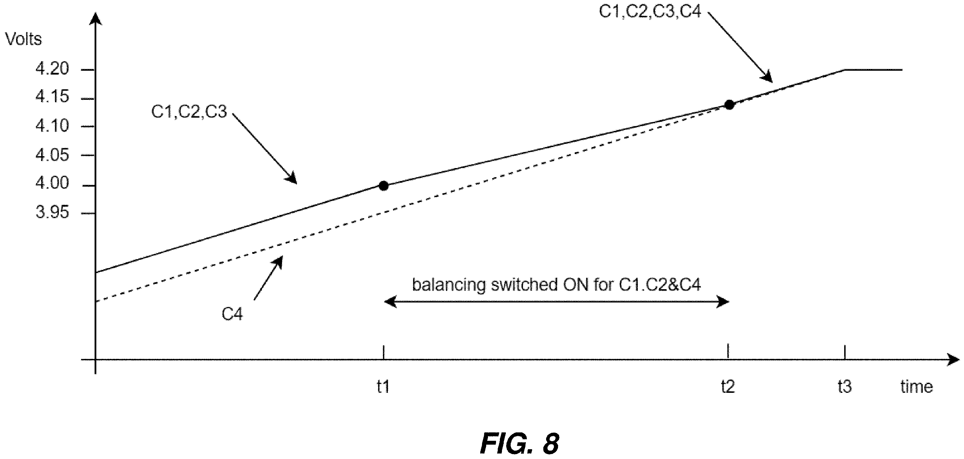

Figure 8 illustrates a working example of the monitoring and control of a cell top balancing process, wherein balancing occurs when individual cells are balanced as they near full charge (or full capacity). Take a set of 4 cells C1, C2, C3 and C4, which are connected in series. Each cell has a nominal capacity lAmp-hr (1Ah). Each cell has a measured voltage VI, V2, V3 and V4. In the present example, the maximum allowed voltage on any cell is 4.2V. The minimum allowed voltage is 3.0V. Using the example embodiments presented herein, the voltage on each cell may be continuously measured.

The cells are placed on a charger circuit, and a 1000mA current is fed through the cells. After some time t1, VI, V2 and V3 are all at 4.00V. This voltage equates to an SOC of 95%. V4 though sits at 3.95V. This is because C4 has suffered excess self discharge because it has been, for example, at a higher temperature than the other cells, and the pack has not been balanced. This voltage equates to a SOC of 93%. Thus, cell C4 is 2% of 1Ah = 20mAh lower charge than the other cells. Each cell has a 40Ω balance resistor which can be switched on and off by a MOSFET.

Switching the balance resistor (R_{bal}) on, when the cell voltage is 4.00V, this will cause a 100mA current to flow. This 100mA current bypasses the cell, reducing the charge current to that cell from 1000mA to 900mA. In order to balance the four cells, the balance resistor on C1, C2 and C3 is switched on. Cells C1, C2 and C3 are now charging at 900mA. Cell C4 continues to charge at 1000mA. All four cells continue to charge towards their maximum allowed voltage of 4.20V.

C1, C2 and C3 are now charging at only 900mA. 100mA is bypassed around each cell, C1-C3. Because they are at 95% SOC, they require 5% of 1Ah = 50mAh to reach full charge. This will take 50mAh x 60x60 / 900mA = 200 seconds. Because C4 is charging 100mA faster than C1,C2 and C3, it will reach full charge in 50mAh x 60x60 / 1000mA = 180seconds. At time t2, before 180 seconds has elapsed, at the cell voltage may be identical at 4.15V. At this time, the balancing is stopped as all cells are now in balance. Charging continues with all cells at 1000mA until t3, when the maximum allowed voltage of 4.2V is reached. At this time charging must stop. If any cells reach the maximum allowed voltage of 4.2V before balancing is complete, then charging and balancing terminates.

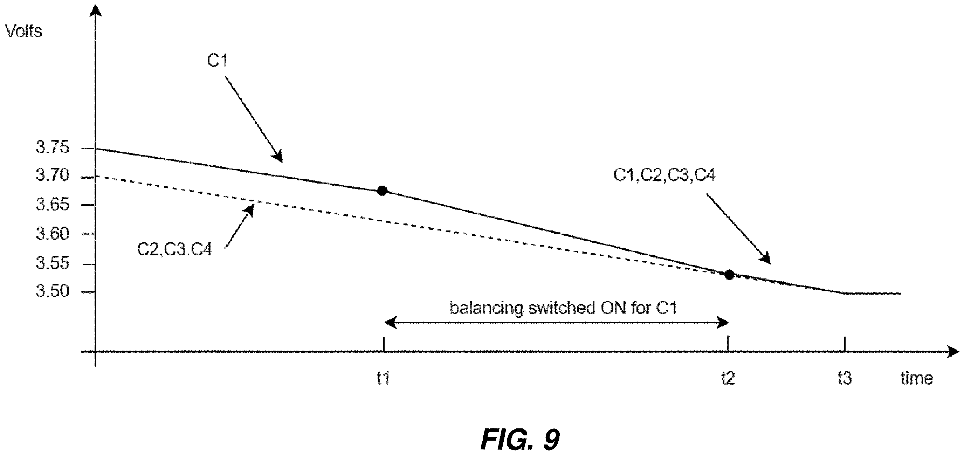

Figure 9 illustrates a working example of the monitoring and control of a cell bottom balancing process. At t1, it is determined that C1 has a higher cell voltage than the others, so balancing is turned on. C1 is now discharging at 1100mA, until t2 when the voltages are all equal. Discharge continues until t3, when it must stop as the minimum allowed voltage is reached. If any cells reach the minimum allowed voltage of 3.5V before balancing is complete, then discharging and balancing terminates.

When balancing is on, the balancing current will cause a shift in the cell voltage. For instance, in the top balancing example case of Figure 8, the reduction in the charge current on C1, C2, and C3 from 1000mA to 900mA will cause the cell voltage to increase by a small amount. If charging was to be terminated when V1 (or V2, V3) hits the allowed maximum, and C1, C2, and C3 were still balancing, such that C4 was still charging at the higher rate, then on termination of charging, C4 would increase in voltage by a larger amount than C1, C2, and C3. In practice, the charger circuit would go into a constant voltage - constant current charging mode, whereby the charge current is gradually reduced while keeping the cell voltage nearly constant. But the charging current interferes with this, since on removal of balancing, C4 will change by a different amount to C1, C2, and C3. This makes the charge and balance process less precise.

The description of the example embodiments provided herein have been presented for purposes of illustration. The description is not intended to be exhaustive or to limit example embodiments to the precise form disclosed, and modifications and variations are possible in light of the above teachings or may be acquired from practice of various alternatives or equivalents to the provided embodiments. The examples discussed herein were chosen and described in order to explain the principles and the nature of various example embodiments and its practical application to enable one skilled in the art to utilize the example embodiments in various manners and with various modifications as are suited to the particular use contemplated. The features of the embodiments described herein may be combined in all possible combinations of methods, apparatus, modules, systems, and computer program products. It should be appreciated that the example embodiments presented herein may be practiced in any combination with each other.

It should be noted that the word "comprising" does not necessarily exclude the presence of other elements or steps than those listed and the words "a" or "an" preceding an element do not exclude the presence of a plurality of such elements. It should further be noted that any reference signs do not limit the scope of the claims, that the example embodiments may be implemented at least in part by means of both hardware and software, and that several "means", "units" or "devices" may be represented by the same or functionally equivalent item of hardware.

The various example embodiments described herein are described in the general context of method steps or processes, which may be implemented in one aspect by a computer program product, embodied in a computer-readable medium or a non-transitory computer-readable medium, comprising computer-executable instructions, such as program code, executed by computers or one or more processors in networked environments. A computer-readable medium or a non-transitory computer readable medium may comprise removable and non-removable storage devices comprising, but not limited to, Read Only Memory (ROM), Random Access Memory (RAM), compact discs (CDs), digital versatile discs (DVD), flash memories, etc. Generally, program modules may comprise routines, programs, objects, components, data structures, etc. that perform particular tasks or implement particular abstract data types. Computer-executable instructions, associated data structures, and program modules represent examples of program code for executing steps of the methods disclosed herein. The particular sequence of such executable instructions or associated data structures represents examples of corresponding acts for implementing the functions described in such steps or processes.

In the drawings and specification, there have been disclosed example embodiments. However, many variations and modifications can be made to these embodiments. Accordingly, although specific terms are employed, they are used in a generic and descriptive sense only and not for purposes of limitation, the scope of the embodiments being defined by the following claims.

## Claims

1. A method, in a battery pack of an electric battery system, for balancing cells within the battery pack with respect to voltage, charge and/or state of charge, wherein the electric battery system comprises at least one pack, each pack comprising a plurality of battery cells, wherein each battery cell is monitored via a cell monitoring device, CMD, which provides cell-level measurements, the method comprising:
obtaining, with at least one sensor comprised in a respective CMD, a cell-level voltage measurement and/or a cell-level charge measurement of the respective cell;
identifying at least one cell of the plurality of battery cells to undergo cell balancing based on the respective cell-level voltage measurement, cell-level charge measurement and/or a determined cell-level state of charge;
balancing the at least one identified cell of the battery pack via a charging or discharging of the at least one identified cell; and
measuring a cell-level balancing current of the at least one identified cell during the balancing, and controlling the balancing of the at least one identified cell based on the measured cell-level balancing current.

2. The method of claim 1, wherein the identifying at least one cell further comprises self-identifying, via the CMD of each respective cell, based on:
a voltage, charge or state of charge, of a respective cell, surpassing a deliberate voltage or charge target threshold; or
a voltage, charge or state of charge not falling within a predefined bottom balancing threshold of voltage or charge; or
a voltage, charge or state of charge difference of a respective cell in relation to at least one other cell within the battery pack.

3. The method of claim 1, wherein the identifying at least one cell further comprises:
transmitting, via a radio antenna of each respective CMD, to a centralized control unit, the cell-level voltage, state of charge, and/or charge measurement via a wireless communications bus, wherein the centralized control unit is configured to control operations of the electric battery system; and
receiving, via the radio antenna of each respective CMD, from the centralized control unit, instructions to cell balance at least one cell based on the respective the cell-level voltage, state of charge, and/or charge measurement.

4. The method of any of claims 1-3, wherein the controlling the balancing based on the measured cell-level balancing current further comprises:
controlling a duration of the balancing of the at least one identified cell; and/or
detecting faults within the cell-level balancing current; and/or
modulating a duty cycle of the cell-balancing current to obtain an average current.

5. The method of any of claims 1-4, further comprising measuring a cell-level voltage during the balancing of the at least one identified cell, wherein said controlling further comprises:
detecting when the measured cell-level voltage is below a minimal or maximum cell-level voltage for maintaining cell operation; and/or
adjusting cell balancing voltage limits during the balancing of the at least one identified cell.

6. The method of claims 4 and 5, wherein the controlling based on the measured cell-level balancing current and the measured cell-level voltage further comprises:
calculating a state of charge during the cell balancing of the identified cell; and/or
calculating energy values of the respective undergoing cell balancing via an integration of the measured cell-level balancing current and the measured cell-level voltage over time.

7. A battery pack comprising a plurality of cell monitoring devices, CMDs, for balancing cells within the battery pack with respect to voltage, charge and/or state of charge, wherein the battery pack comprises a plurality of battery cells, wherein each battery cell is monitored via a respective cell monitoring device, CMD, which provides cell-level measurements, wherein each CMD comprises:
a measuring unit comprising at least one sensor configured to obtain a cell-level voltage measurement and/or a cell-level charge measurement of the respective cell;
a balance control unit configured to identify a respective cell for cell balancing based on the measured cell-level voltage, the measured cell-level charge and/or a determined state of charge of the respective cell;
the balance control unit further configured to balance the respective cell via a discharging or charging of the respective cell; and
the balance control unit further configured to measure a cell-level balancing current of the respective cell during the cell balancing, and further configured to control the cell balancing of the respective cell based on the measured cell-level balancing current.

8. The battery pack of claim 7, wherein the balancing control unit of each CMD is further configured to perform the method of any one of claims 2-6.

9. The battery pack of any of claims 7 and 8, wherein the balancing control unit of each CMD is further configured to measure a cell-level balancing current by measuring a cell-level voltage during the cell balancing across a balancing resistor comprised within the CMD.

10. The battery pack of claim 9, wherein the balancing control unit of each CMD is further configured to calculate a cell voltage error based on the cell-level balancing current on a resistance of a common connection for a power supply of the respective CMD and the measuring unit of the respective CMD, from the respective cell to the respective CMD.

11. The battery back of claim 9, wherein at least one respective CMD comprises a separate connection for a power supply and the measuring unit via a kelvin connection between the at least one respective CMD and the respective cell.

12. The battery pack of any of claims 9-11, wherein each CMD further comprises a FET switch in connection with the balancing control unit.

13. A computer-readable medium storing instructions which, when executed by a processor of a respective cell monitoring device, CMD, of a battery pack, cause the respective CMD to execute the method according to any one of claims 1-6.
